Europäisches Patentamt

**European Patent Office**

Office européen des brevets

(11) Publication number: **0 079 161**
**A2**

## (12) EUROPEAN PATENT APPLICATION

(21) Application number: **82305649.4**

(22) Date of filing: **25.10.82**

(51) Int. Cl.³: **H 01 L 33/00**

(30) Priority: **06.11.81 US 319012**

(43) Date of publication of application:
**18.05.83 Bulletin 83/20**

(84) Designated Contracting States:
**AT BE DE FR GB IT NL**

(71) Applicant: **AMP INCORPORATED**
**Eisenhower Boulevard**
**Harrisburg Pennsylvania(US)**

(72) Inventor: **Lockard, Joseph LaRue**
**413 Bristol Drive**
**Harrisburg Pennsylvania 17109(US)**

(74) Representative: **Gray, Robin Oliver et al,**
**20 Queensmere Slough**
**Berkshire, SL1 1YZ(GB)**

(54) **LED lamp and mounting base therefor.**

(57) An LED lamp comprises a light-emitting member (36) having leads (12, 14) connected thereto which extend outwardly from a lens member (4) in which the light-emitting member (36) is disposed. A base member (2) has the lens member (4) mounted therein. The base member (2) includes holes (18) extending therethrough and the leads (12, 14) are disposed within the base member (2) with post-engaging sections (20) being coincident with the axes of the holes (18) whereby the post-engaging sections (20) frictionally and electrically engage post member (46) of a board (48).

FIG.1

## LED LAMP AND MOUNTING BASE THEREFOR

This invention relates to LED lamps and mounting bases therefor to enable the LED lamps to be electrically mounted on pins of a PCB. One of the leads of the lamp connected to the LED has a cup shape in which the LED is disposed to concentrate the light and the other lead is connected directly to the LED. A tool is used to position the LED lamps onto the PCB pins and to remove them therefrom.

LED lamps have been typically soldered to PCBs. One approach has been to mount the LED lamps in front panel housings and then hand-solder the leads to an adjacent PCB. Another approach has been to cut the leads of LED lamps to size, form them so they will properly fit into holes in the PCB and then flow-solder them in place. A further approach has been to use locating means to locate the leads of the LED lamps relative to the PCB holes, hold them in position, and then solder the leads in position.

These approaches require time to position and solder the LED lamps in position and if they are flush mounted onto the board, risk damage to the lamps from heat.

According to the present invention, an LED lamp comprises a light-emitting member having leads connected thereto which extend outwardly from a lens member in which the light-emitting member is disposed. A base member has the lens member mounted therein. The base member includes holes extending therethrough and the leads are disposed within the base member with post-engaging sections being coincident with the axes of the holes whereby the post-engaging sections frictionally and electrically engage the post members.

According to another aspect of the present invention, one of the leads for the light-emitting member has a cup shape in which the light-

9651

emitting member is disposed, and it is oriented substantially normal to the axis of the lamp. The other of the leads is profiled to a point and makes point contact with the light-emitting member. This arrangement concentrates the light along the axis toward the viewing end of the lamp.

According to a further aspect of the invention, a tool is provided that engages the base member of the LED lamp to position the LED lamp onto the PCB posts and to remove it therefrom.

According to an additional aspect of the invention, a method of making LED lamps comprises the steps of molding a mounting base onto leads of a lead frame, plating the leads with a soldering material, placing an LED chip into a cup of one of the leads, reflow-soldering the leads to the chip, inserting the leads and chip into encapsulating and light-transmitting material, and curing the encapsulating material.

FIGURE 1 is a perspective view of an LED lamp with parts broken away.

FIGURES 2-5 are perspective exploded views showing the LED lamp mounted in various ways onto posts of a PCB.

FIGURE 6 is a perspective view of a lead frame of the leads for LED lamps.

FIGURE 7 is a top plan view of Figure 6 showing a mounting base on a set of leads.

FIGURE 8 is a view taken along line 8-8 of Figure 7.

FIGURE 9 is a perspective view of the contact sections of the leads with a die connected therewith.

FIGURE 10 is a cross-sectional view showing the lead frame, mounting bases and leads with their contact sections immersed within potting material of lens members.

FIGURE 11 is a perspective exploded view showing a tool to mount an LED lamp onto posts of a PCB and to remove same therefrom.

FIGURE 12 is the same as Figure 11 showing the LED lamp mounted onto the PCB posts.

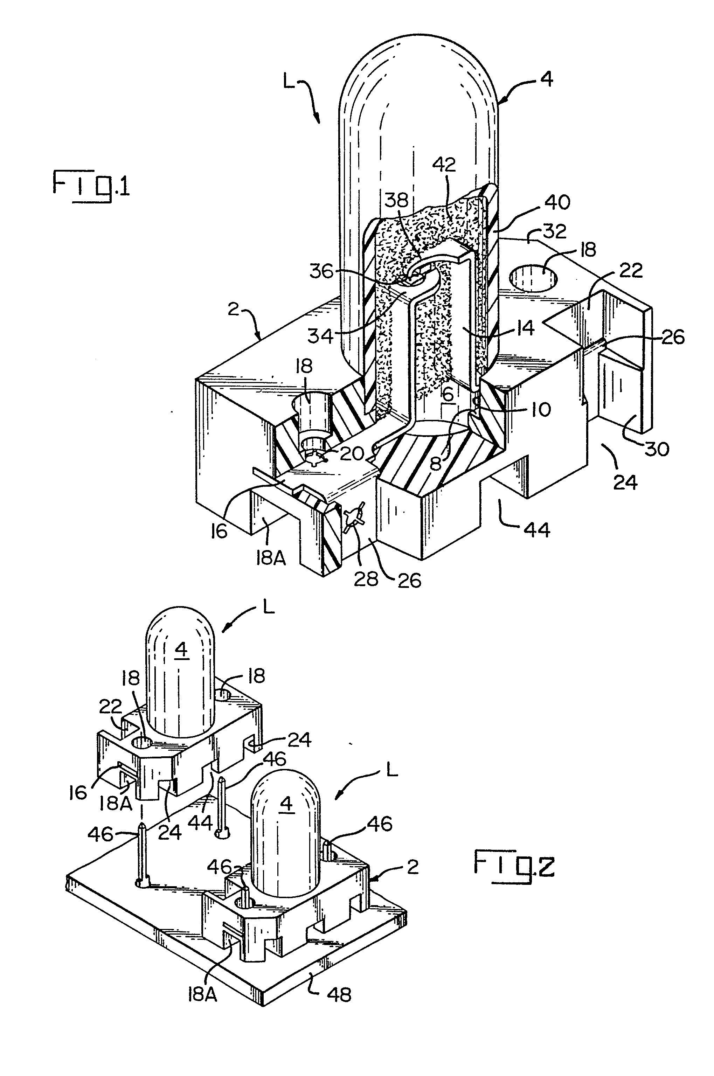

An LED lamp L is shown in Figures 1 through 5 which includes a mounting base 2 and a lamp member 4. Mounting base 2 is molded from a suitable commercially-available plastic material and it includes an opening 6 extending to a shoulder 8 which merges into an annular recess 10. Lead

9651

members 12, 14 are disposed within mounting base 2 with each lead member having a leg member 16 extending across holes 18. Holes 18 merge into recesses 18a in the bottom of mounting base 2. A cross-shaped opening 20 is located in each of leg members 16 coincident with the axis of each of holes 18. Channels 22 are located in mounting base 2 and they communicate with recesses 24 which extend normal to holes 18. Leg members 16 include tabs 26 which extend across recesses 24 and also include cross-shaped openings 28 coincident with the axes of recesses 24. Beveled projections 30 are located on the opposing walls of channels 22 and they maintain extensions 26 in position. Mounting base 2 has a beveled corner 32 to identify the positive terminal of the LED lamp.

Lead member 12 has a cup-shaped section 34 in which a light-emitting member 36 such as a light-emitting diode is disposed. Lead member 14 has a point contact section 38 which is necked down and curved to make point contact with light-emitting member 36. Light-emitting member 36 is electrically connected to cup-shaped section 34 and point contact section 38 via conventional reflow-soldering techniques.

A dome-shaped member 40 of commercially-available thermoplastic material is disposed in annular rece s 10 and in engagement with shoulder 8. A commercially-available epoxy potting material 42 is disposed in dome-shaped member 40 to secure member 40 in position on mounting base 2 and to encapsulate light-emitting member 36 in electrical connection with cup-shaped section 34 and point contact section 38 and portions of lead members 12, 14 therein.

Dome-shaped member 40 has the same index of refraction as the epoxy potting material 42, thereby forming a lens structure for the light-emitting member. The orientation of cup-shaped section 34 directs the light emanating from light-emitting member 36 along the axis of lamp member 4 thereby concentrating the emitted light out the lighted end thereof and the necked-down configuration of point contact section 38 minimizes interference with the emitted light. A recess 44 extends across the bottom of mounting base 2 normal to the axis of lamp member 4.

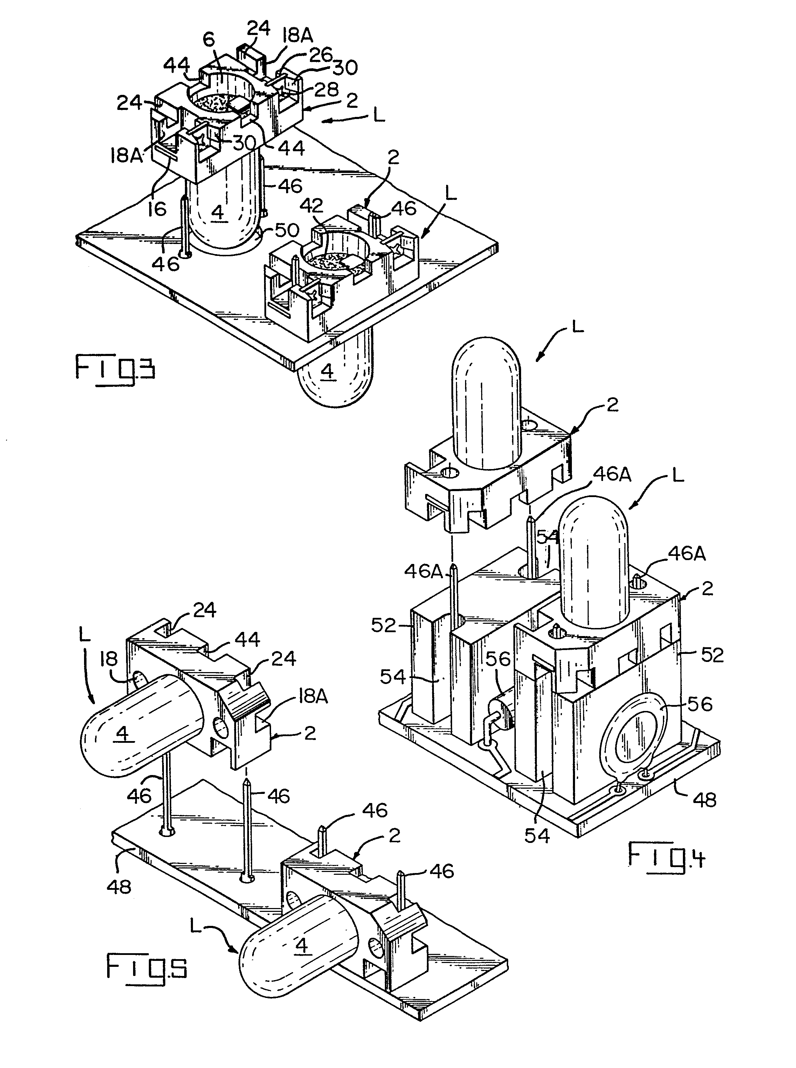

Figure 2 shows lamp L being mounted onto posts 46 secured in openings of a printed circuit board 48 and soldered to appropriate circuitry thereon. As shown in Figure 2, posts 46 extend through holes

9651

18 and through cross-shaped openings 20 which frictionally grasp posts 46 to mechanically maintain lamp L in position on posts 46 and in electrical engagement with board 48. Base 2 spaces the operating elements of lamp L from board 48 and recess 44 enables air to flow through base 2 thereby dissipating the heat generated by lamp L and increasing its operating life.

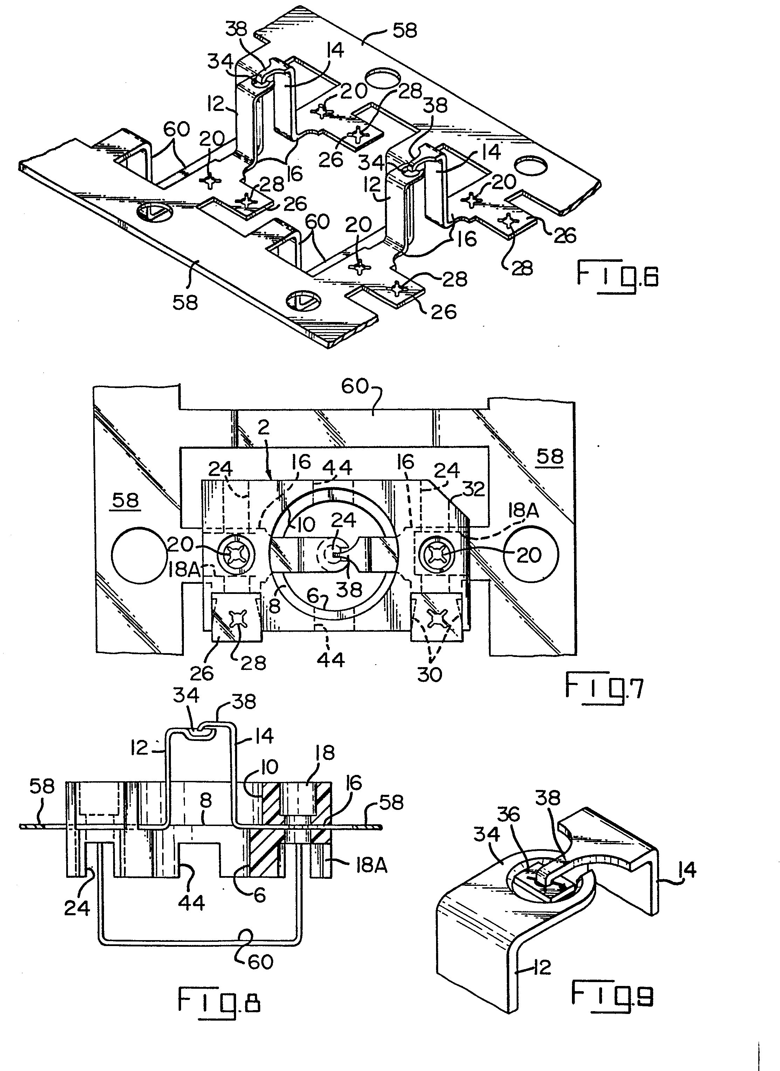

Figure 3 illustrates lamp L being mounted on posts 46 of board 48 such that lamp member 4 extends through a hole 50 in board 48 between posts 46.

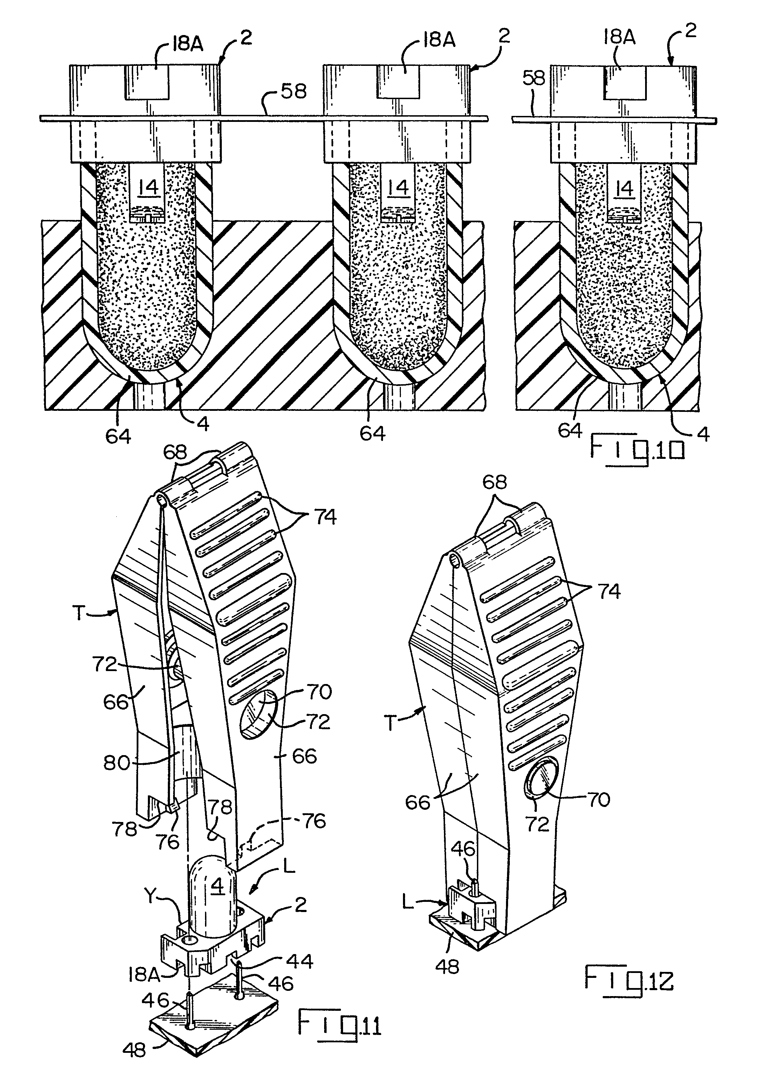

Figure 4 is similar to the embodiment of Figure 2 except that posts 46a are longer than posts 46 and a dielectric spacer having U-shaped recesses 54 to accommodate posts 46a when mounted on board 48 between posts 46a and lamp L is mounted on posts 46a in the same manner as shown in Figure 2 except that mounting base 2 is positioned in engagement with spacer 52 when posts 46a frictionally and electrically engage cross-shaped openings 20. The embodiment of Figure 4 enables board 48 to have electronic components 56 mounted thereon and board 48 to be mounted onto a panel with lamps L extending through openings therein.

The embodiment shown in Figure 5 enables lamps L to be mounted on posts 46 such that posts 46 frictionally and electrically engage. cross-shaped openings 28 in tabs 26 so that lamps L are preferably mounted along the edge of board 48 with the axis of lamp member 4 extending parallel with respect to the surfaces thereof. For example, this enables board 48 to be mounted in a card cage so that lamp member 4 extends therefrom for indicating purposes.

Figures 6 through 10 illustrate a method of making LED lamps L. A lead frame 58 has stamped and formed therein lead members 12, 14 which are connected to lead frame 58 via leg members 16. U-shaped straps 60 are located between each set of lead members 12, 14 to maintain the lead members properly positioned relative to one another and cup-shaped sections 34 positioned relative to point contact sections 38. Lead frame 58 is then positioned in a mold (not shown) so that mounting bases 2 are molded to leg members 16 of lead members 12, 14. After mounting bases 2 are molded to leg members 16 of each set of lead members 12, 14, straps 60 are removed from lead frame 58 and tabs 26 are bent into channels 24 along beveled projections 30 until they are disposed in recesses 24 and

9651

beveled projections 30 latch them in position therein. The removal of straps 60 and the bending of extensions 26 into position can be done simultareously or separately as desired. Moreover, tabs 26 can be bent into their post-engaging positions prior to mounting bases 2 being molded onto leg members 16.

With mounting bases 2 molded into position and straps 60 removed, lead frame 58 is retained as a lead frame via mounting bases 2 and this enables lead frame 58 to be subjected to a conventional plating operation wherein lead members 12, 14 are plated with a conventional tin-lead plating whereafter light-emitting members 36 are properly positioned in cup-shaped sections 34 and point contact sections 38 are positioned into spring contact therewith. Heated air is then directed onto this assembly causing a reflow-soldering operation to take place so that cup-shaped sections 34 and point contact sections 38 are soldered to respective negative and positive surfaces of light-emitting members 36.

The assembly can now be tested to determine whether or not the light-emitting members are properly operating and a proper solder connection has been effected. Defective assemblies are not processed any further thereby eliminating them at this stage of the manufacturing operation.

A holder has holes 64 disposed therein which receive dome-shaped members 40 therein. Epoxy potting material 42 is dispensed in dome-shaped members 40 and lead members 12, 14 with light-emitting members 36 soldered in position are placed in potting material 42 with shoulders 8 of mounting bases 2 engaging the inner end of dome-shaped members 40 when they are positioned within annular recesses 10 of mounting bases 2. The metal holders with the LED lamps therein are then heated to thereby cure the potting material whereafter leg members 16 are severed from lead frame 58 along the sides of mounting base 2 thereby completing the manufacture of LED lamps L.

Figures 11 and 12 illustrate a tool T for manually inserting a lamp L in position onto posts 46 in board 48 and to remove it therefrom. Tool T is molded from a commercially-available plastic material and it includes identical leg members 66 which are hinged together by integral spring hinges 68. A rivet 70 extends through openings 72 in each of leg members 66; rivet 70 retaining leg members 66 in a normally open position as illustrated in Figure 11 by virtue of integral spring hinges 68. Spaced projections 74 are located along each leg member 66 to enable an operator to operate the tool without slipping.

Tapered lugs 76 are located at the free ends of leg members 66 for engagement with recesses 44 and 18a of mounting base 2 and abutments 78 spaced inwardly from lugs 76 engage the top surface of mounting base 2 with arcuate areas 80 located in abutments 78 surrounding lamp member 4.

In use, leg members 66 are moved toward one another with a lamp in position therebetween so that lugs 76 are disposed in recess 44, lamp member 4 is positioned within arcuate areas 80 and abutments 78 engage the top surface of mounting base 2 and the leg members containing lugs 76 engage the sides of mounting base 2 whereafter lamp L is moved along posts 46 with posts 46 engaging cross-shaped openings 20 which frictionally engage post members 46 as lamp L is moved along posts 46 until mounting base 2 engages board 48. Cross-shaped openings 20 are bent slightly upwardly when posts 46 extend therethrough, and this action of frictional engagement therebetween results in an excellent mechanical and electrical connection therebetween as well as providing a wiping action to break down any oxide coatings thereon.

Tool T can also be used in the same manner to remove lamp L from posts 46 for replacement purposes.

Tapered lugs 76 confine base 2 against abutments 78 and clamped by pressure on legs 66. The lamp L is projecting down. The lamp is inserted into the hole 50 between the posts 46. Posts 46 are located in the holes 18 and force is applied to push the lamp onto the posts.

A lamp L is located in the jaws of the tool with sides against abutments 78. The lens protrudes at a right angle to the axis of the tool. The lugs 76 enter slots 18a to confine the lamp and pressure on members 66 clamps the lamp in place. The lamp is pushed onto posts with posts entering openings 28.

While tool T is used to manually mount lamps L onto posts of a PCB, the present invention lends itself to machine insertion.

9651

CLAIMS:

1. An LED lamp of the type comprising electrical leads (12, 14) with one of the electrical leads (12) having a cup-shaped section (34) in which a light-emitting member (36) is disposed and has one side electrically connected to the cup-shaped area while the other electrical lead (14) is electrically connected to the other side of the light-emitting member (36) and a lens (4) encapsulating the electrical leads (12, 14) and light-emitting member (36), characterized in that:

said electrical leads (12, 14) have leg members (16) secured in an insulating base member (2) with cross-shaped openings (20) coincident with the axes of holes (18) in base member (2) to enable the cross-shaped openings (20) to frictionally and electrically engage electrical posts (46) of a board member (48).

2. An LED lamp as set forth in claim 1 characterized in that said leg members (16) have tabs (26) provided with cross-shaped openings (28) in axial alignment with recesses (24) in said base member (2).

3. An LED lamp as set forth in claim 2 characterized in that said base member (2) has beveled projections (30) maintaining said tabs (26) in position in said recesses (24).

4. An LED lamp as set forth in claim 1 characterized in that said electrical lead (14) has a point contact section (38) connected to the other surface of the light-emitting member (36).

5. An LED lamp as set forth in claim 4 characterized in that said cup-shaped section (34) extends normal to and its axis is coincident with the axis of said lens (4).

6. An LED lamp as set forth in claim 1 characterized in that said base member (2) has recesses (18A, 44) in which projections (76) of legs (66) of a tool (T) are disposed to force the cross-shaped openings (20) into frictional and electrical engagement with electrical posts (46) or to remove the LED lamp from electrical posts (46).

7. A method of making an LED lamp (L) characterized by the steps of:

stamping and forming a strip of metal into a lead frame comprising sets of lead members (12, 14) having leg members (16) and contact

9651

sections (34, 38) and strap members (60) between said sets of lead members (12, 14);

molding an insulating base member (2) onto said leg members (16) of each of said sets of lead members (12, 14);

plating said contact sections (34, 38) with solder material;

placing a light-emitting member (36) in between said contact sections (34, 38);

reflow-soldering said contact sections (34, 38) to said light-emitting member (36);

inserting said contact sections (34, 38) with said light-emitting member (36) and portions of said lead members (12, 14) into a curable light-transmitting lens member (4); and

curing said curable light-transmitting lens member (4) thereby forming LED lamps with said lens member (4) secured to said base member (2).

8. A method as set forth in claim 7 characterized by the further step of bending tabs (26) of said leg members (16) into recesses (24) of said base member (2).

9. A method as set forth in claim 7 characterized by the further step of removing said strap members (60) after said base members (2) have been molded to said leg members (16).

10. A method as set forth in claims 17 and 18 characterized by the fact that said bending and removing steps can be done simultaneously.

11. A method as set forth in claim 9 characterized by the further step of testing the light-emitting members (36) after said strap members (60) have been removed.

9651

Fig.1

Fig.2

FIG3

FIG4

FIG5

Fig.6

Fig.7

Fig.8

Fig.9

FIg.10

FIg.11

FIg.12